# EUROPEAN PATENT APPLICATION

(11) **EP 4 607 570 A1**
(43) Date of publication of application: **27.08.2025**
(21) Application number: 24159294.8
(22) Date of filing: 23.02.2024
(51) Int. Cl.: H01J 37/20, H01J 37/26, H01J 37/28

(54) **SAMPLE TIP**

(71) Applicant: FEI COMPANY, Hillsboro, OR 97124 (US)
(72) Inventor: VERWIMP, Nick, Eindhoven (NL); POTOCNAK, Tomas, Eindhoven (NL)
(74) Representative: Robinson, Louise Frances

(57) **Abstract**

The invention relates to a sample holder tip (hereinafter referred to as the sample tip) for releasably holding a sample, wherein the sample tip comprises: a cradle comprising beryllium, with a recess for releasably receiving a sample, and a bumper comprising aluminium. In particular, the invention relates to a sample tip that may be used in a charged particle microscope.

## Description

### Background

The invention relates to a sample holder tip (hereinafter referred to as the sample tip) for releasably holding a sample, wherein the sample tip comprises: a cradle comprising beryllium, with a recess for releasably receiving a sample, and a bumper comprising aluminium. In particular, the invention relates to a sample tip that may be used in a charged particle microscope.

Various types of optical devices are well-known in the field of electron microscopy to create a magnified image of an object, feature or component that is generally too small to be seen by the naked eye. Such devices may include the Transmission Electron Microscope (TEM), Scanning Electron Microscope (SEM), and Scanning Transmission Electron Microscope (STEM). Imaging of a sample is typically achieved by detecting emanations or output radiation from the sample caused by irradiation of the sample by the imaging beam. Such emanations may include secondary electrons, backscattered electrons, X-rays, light (visible light and near visible light such as near-IR and near-UV), and any combination of these. These imaging devices may be part of a "dual beam" system with an additional tool having a machining function to modify a sample by removing material, such as by milling or ablation, or adding material, such as by deposition. For example, such a dual beam system may include a Focused Ion Beam (FIB) for machining and an electron microscope for imaging.

In a process called "Energy Dispersive X-Ray Spectroscopy" or "EDS", the energy of the x-rays of a response electron beam from a sample is measured and plotted in a histogram to form a material-specific spectrum. The measured spectrum can be compared to the known spectra of various elements to determine which elements and minerals are present in the sample.

However, EDS can suffer from certain disadvantages such as the introduction of spurious peaks from materials present in the equipment, such as the sample holder.

### Summary of the Invention

It is therefore an object of the present invention to provide an improved holder for samples analysed by EDS, which aims to enable a high solid angle towards the EDX detector, provide additional collimation of the EDX detector, enable high P/B, suppression of spurious peaks generated from holder/detector surrounding environment, as well as providing a robust and usable design.

The present invention addresses this by the provision of a sample tip for releasably holding a sample, wherein the sample tip comprises:
a cradle comprising beryllium, with a recess comprising an opening or void, for releasably receiving a sample; and
a bumper comprising aluminium.

The sample tip may preferably be used in a charged particle microscope, in particular, a charged particle microscope comprising an EDX detector.

The cradle in the sample tip typically comprises a first surface and a second surface that are substantially parallel to each other.

The term "substantially" as used herein is intended to mean that the feature referred to has approximately the features described rather than the exact features described. For example, substantially parallel is intended to mean that the surfaces lie in the same direction but may deviate from being the exactly the same distance apart, and substantially circular is intended to mean that the feature may have an approximately circular shape, rather than a perfect circular shape. The feature referred to may deviate from the "exact" feature from about 1.0% to about 0.001%, such as from about 0.5% to about 0.1%.

The cradle comprises beryllium. In a preferred aspect of the invention the cradle may consist essentially of beryllium or consist of beryllium.

For the avoidance of doubt, in this specification when we use the term "comprising" or "comprises" we mean that the feature being described must contain the listed ingredient(s) but may optionally contain additional ingredients. When we use the term "consisting essentially of" or "consists essentially of" we mean that the feature being described must contain the listed ingredient(s) and may also contain small (for example up to 5% by weight, or up to 1 % or 0.1 % by weight) of other ingredients provided that any additional ingredients do not affect the essential properties of the feature. When we use the term "consisting of" or "consists of" we mean that the feature being described must contain the listed ingredient(s) only.

The cradle may preferably be symmetrical. For example, the cradle may have at least one plane of symmetry.

The cradle may have at least two curved sides and at least two straight sides. Typically, the curved sides are opposite each other and the straight sides are opposite each other, i.e. the cradle has two planes of symmetry.

The cradle may be any shape, but it is preferred that the shape or geometry of the cradle minimises cradle material in the direct path between the primary generated x-rays and the detector surface.

It may be preferred that the cradle has a low profile, especially a low profile when surrounded by the bumper, i.e. the cradle does not extend beyond the upper and/or lower surface of the bumper.

The recess comprises an opening or a void within the recess. Typically, the opening or void is from about 5% to about 20% smaller than the recess leaving a recessed area of the cradle around the opening or void.

The recess of the cradle may be positioned on the first surface of the cradle and the second surface of the cradle may preferably slope from the outer edge of the cradle towards the opening or void, or vice versa.

The recess may have any shape but may preferably have a substantially circular shape. For example, the recess may have the shape of a circular sample grid, such as a sample grid for a charged particle microscope.

In a preferred aspect, the recess may have a shape such that a sample grid (such as a sample grid for a charged particle microscope) may fit within the recess.

As used herein, the term "sample grid" includes all grids suitable for holding a sample, such as a half-moon grid or a thin film structure. In particular, the sample grid includes all grids that may be used in a charged particle microscope.

The void or opening may have the same shape as the recess or different. Typically, the void or opening has the same shape as the recess. For example, the recess and opening/void may be substantially circular.

The bumper of the sample tip may comprise, consist essentially of or consist of aluminium.

The bumper may releasably connect on one side to a sample holder and/or a sample stage. However, in some aspects, it may be necessary for the sample holder and/or sample stage to releasably connect to the cradle.

Depending on the connection point, the bumper may surround from about 75% to about 100% of the perimeter of the cradle.

For example, where the bumper is releasably connected to the sample holder and/or sample stage, the bumper may preferably surround 100% of the cradle.

However, where the cradle is releasably connected to the sample holder and/or sample stage, the bumper may preferably surround less than 100% of the cradle to allow connection between the cradle and the sample holder and/or sample stage. For example, the bumper may surround from about 75% to about 90% of the cradle, such as from about 75% to about 80% of the cradle.

As used herein, "surround" is intended to mean that the bumper is positioned around the external perimeter of the cradle. The bumper may touch the cradle around the whole perimeter or may only touch the cradle at specific points, as shown in the figures.

The bumper typically extends in the same place as the cradle.

Using the Cartesian coordinate system, the sample tip T (including the bumper and the cradle) typically extends in the XY plane.

The bumper may be any shape but may preferably comprise at least two straight sides. For example, the bumper may be substantially quadrilateral in shape, such as a square or rectangle.

The bumper may comprise a first and second surface, where the first and second surface slope from the outer edge of the bumper towards the cradle.

The bumper (and consequently the sample tip) has a proximal and a distal end, where the proximal end is the end that may be releasably connected to the sample holder and/or sample stage.

The cradle may be positioned centrally in the bumper or may be slightly offset. That is the cradle may be positioned closer to one side of the bumper. For example, the cradle may be positioned closer to the side of the bumper that releasably connects to the sample holder and/or sample stage, i.e. the proximal end.

Typically, the cradle and bumper are formed independently and then assembled such that the cradle may be removably positioned in the bumper. However, in certain circumstances it may be necessary to form the cradle and bumper together.

The sample tip may preferably comprise at least one fixing element.

The fixing element may comprise a clamping member that is movably connected to the bumper or the cradle.

Said clamping member is movable between a closed and an open position. In the open position, the clamping member is positioned in such a way that said sample carrier can be placed in said recess. In the closed position, the clamping member is arranged for directly, or indirectly, locking said sample carrier in said recess.

The movable clamping member that is connected to the bumper or the cradle allows for improved attachment of the sample carrier with said sample to said sample holder. Attachment can occur in a fast and reliable manner by moving the clamping member to the open position, placing the sample carrier in the recess, and simply moving the clamping member to the closed position again.

As the clamping member is connected to the bumper or cradle, moving the clamping member between the open position and the closed position is relatively easy, and the movement of the clamping member provides a reliable way of securing the sample carrier in the sample tip. With this, a reliable, secure and fast way of mounting the sample carrier in the sample tip is obtained.

Additionally, the use of a movable clamping member provides the possibility for embodying the tip in a very compact way. A compact construction is beneficial, as it allows, for example, tilting of the sample. Further, a compact construction aids in establishing a large opening angle for EDX analysis, for example.

Advantageous embodiments will be explained below.

The clamping member may be pivotable between said open position and said closed position. Pivoting the clamping member allows for a compact construction, as well as for easy manipulation of the clamping member. It is conceivable that the grid is placed on a level surface of the cradle recess, and that the movable clamping member holds the grid in place in the closed position. This provides a compact construction that prevents so called shadowing during study with the TEM.

The clamping member may comprise a spring element. The spring element may provide a desired clamping force to the clamping member, such that the sample carrier is held securely in place. In a further embodiment, the spring element may be arranged for urging said clamping member towards said closed position. This way, the clamping member is forced towards the closed position, holding the sample carrier in place by default. Thus, the reliability of the mounting is increased.

It is conceivable, that said clamping member can be actuated by an actuator member. The actuation member may be actuated automatically, or by a user of the electron microscope, for example.

The actuator member may be arranged for at least pushing said clamping member towards said open position. In combination with a spring element that urges the clamping member towards said closed position, this provides a quick, reliable and easy way of mounting the sample carrier to the sample holder.

The sample tip may comprise least one further fixing element for fixing said sample carrier in said recess of said holder body, i.e. two, three or four fixing elements. By using a further fixing element, a more secure mounting is possible. It is noted that the fixing element and the further fixing element may be different with respect to each other. For example, the fixing element may be the pivotable clamping member, whilst the further fixing element may be a spring element for example. In an embodiment, however, the fixing element and the further fixing element are substantially similar to each other.

According to a further aspect of the invention a charged particle microscope for examining a sample is provided, comprising:
- an optics column, including a charged particle source and an illuminator for directing a beam of charged particles emitted from said charged particle source onto a sample;
- a sample tip according to the present disclosure as defined above, for holding a sample grid with said sample therein, and positioned downstream of said illuminator;
- an EDX detector device for detecting x-ray emissions originating from said sample in response to the incidence of charged particles emitted from said charged particle source; and
- a control unit for performing operations of the charged particle microscope.

The present invention also provides a method for inspecting a sample through multiple charged particle beams, wherein the method comprises:
- providing a charged particle beam;
- providing the sample on a sample tip according to the present disclosure as defined above;
- directing the beam through the sample;
- detecting the energies of the x-rays emitted from the sample.

The invention will next be explained by reference to the accompanying drawings, which show several embodiments of the sample holder as described herein. In the figures:
Fig. 1 - A schematic overview of a charged particle microscope;
Fig. 2a-2b - A schematic overview of an embodiment of the cradle as disclosed herein;
Fig. 3a-3b - A schematic overview of the sample tip in top (plan) view (3a) and front-side (elevation) view (3b);
Fig. 4 - A schematic overview of the sample tip connected to a sample holder as disclosed herein.

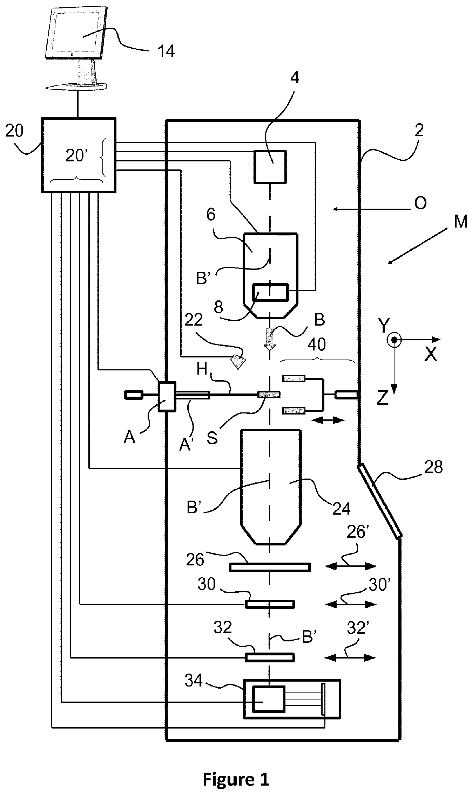

Fig. 1 (not to scale) is a highly schematic depiction of an embodiment of a charged-particle microscope M in which the sample tip as disclosed herein can be used. More specifically, Fig. 1 shows an embodiment of a transmission-type microscope M, which, in this case, is a TEM/STEM (though, in the context of the current invention, it could just as validly be a SEM, or an ion-based microscope, for example).

In Fig. 1, within a vacuum enclosure 2, an electron source 4 produces a beam B of electrons that propagates along an electron-optical axis B' and traverses an electron-optical illuminator 6, serving to direct/focus the electrons onto a chosen part of a sample S (which may, for example, be (locally) thinned/planarized). Also depicted is a deflector 8, which (inter alia) can be used to effect scanning motion of the beam B.

The sample S is held on a sample tip T (not shown) that is mounted to sample holder H, and this sample holder H can be positioned in multiple degrees of freedom by a positioning device A, which moves a stage A' into which holder H is (removably) affixed; for example, the sample holder H may comprise a finger that can be moved (inter alia ) in the XY plane (see the depicted Cartesian coordinate system; typically, motion parallel to Z and tilt about X/Y (so called alpha tilt/beta tilt, respectively). Such movement allows different parts of the sample S to be illuminated/imaged/inspected by the electron beam B traveling along axis B' (in the Z direction) (and/or allows scanning motion to be performed, as an alternative to beam scanning). If desired, a cooling device (not depicted, but known to those skilled in the art) can be brought into intimate thermal contact with the sample holder H, so as to maintain it (and the sample S thereupon) at cryogenic temperatures, for example.

The electron beam B will interact with the sample S in such a manner as to cause various types of "stimulated" radiation to emanate from the sample S, including (for example) secondary electrons, backscattered electrons, X-rays and optical radiation (cathodoluminescence).

In the present invention, the X-rays are detected with the aid of detector device 22, an EDX (Energy-Dispersive X-Ray Spectroscopy) module.

However, supplementally, one can study electrons that traverse (pass through) the sample S, exit/emanate from it and continue to propagate (substantially, though generally with some deflection/scattering) along axis B'. Such a transmitted electron flux enters an imaging system (projection lens) 24, which will generally comprise a variety of electrostatic/magnetic lenses, deflectors, correctors (such as stigmators), etc. In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'.

An image (or diffractogram) of (part of) the sample S will be formed by imaging system 24 on screen 26, and this may be viewed through viewing port 28 located in a suitable part of a wall of enclosure 2. The retraction mechanism for screen 26 may, for example, be mechanical and/or electrical in nature, and is not depicted here.

As an alternative to viewing an image on screen 26, one can instead make use of the fact that the depth of focus of the electron flux leaving imaging system 24 is generally quite large (e.g. of the order of 1 meter). Consequently, various other types of analysis apparatus can be used downstream of screen 26, such as:
TEM camera 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.
STEM camera 32. An output from camera 32 can be recorded as a function of (X,Y) scanning position of the beam B on the sample S, and an image can be constructed that is a "map" of output from camera 32 as a function of X,Y. Camera 32 can comprise a single pixel with a diameter of e.g. 20 mm, as opposed to the matrix of pixels characteristically present in camera 30. Moreover, camera 32 will generally have a much higher acquisition rate (e .g . 106 points per second) than camera 30 (e .g . 102 images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).

As an alternative to imaging using cameras 30 or 32, one can also invoke spectroscopic apparatus 34, which could be an EELS module, for example.

It should be noted that the order/location of items 30, 32 and 34 is not strict, and many possible variations are conceivable. For example, spectroscopic apparatus 34 can also be integrated into the imaging system 24.

In the embodiment shown, the microscope M further comprises a retractable X-ray Computed Tomography (CT) module, generally indicated by reference 40. In Computed Tomography (also referred to as tomographic imaging) the source and (diametrically opposed) detector are used to look through the sample along different lines of sight, so as to acquire penetrative observations of the sample from a variety of perspectives.

Note that the controller (computer processor) 20 is connected to various illustrated components via control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired.

The skilled artisan will understand that the interior of the enclosure 2 does not have to be kept at a strict vacuum; for example, in a so-called "Environmental TEM/STEM", a background atmosphere of a given gas is deliberately introduced/maintained within the enclosure 2. The skilled artisan will also understand that, in practice, it may be advantageous to confine the volume of enclosure 2 so that, where possible, it essentially hugs the axis B', taking the form of a small tube (e.g. of the order of 1 cm in diameter) through which the employed electron beam passes, but widening out to accommodate structures such as the source 4, sample holder H, screen 26, camera 30, camera 32, spectroscopic apparatus 34, etc.

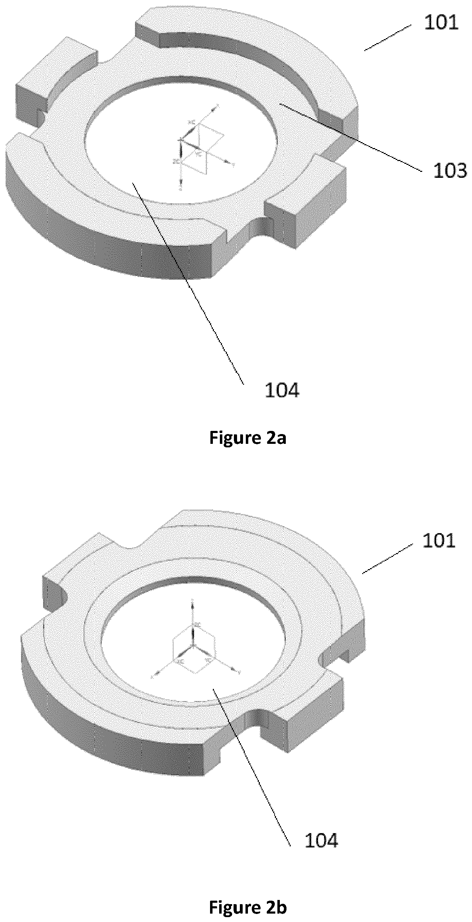

Figures 2a and 2b show an embodiment of the cradle 101 of the sample tip according to the present disclosure, which can be used in a charged particle microscope, such as the transmission electron microscope shown in Fig. 1; but is equally applicable for a SEM or FIB device.

As shown in Figure 2a, the cradle comprises a recess 103 in the first surface. The recess comprises a central opening/void 104.

In Figure 2b, the second surface of the cradle 101 is shown sloping towards the opening/void 104.

In Figures 2a and 2b, the cradle is shown with two curved edges opposite each other and a substantially circular recess and opening/void. However, it may be that other configuration may be utilised depending on the situation.

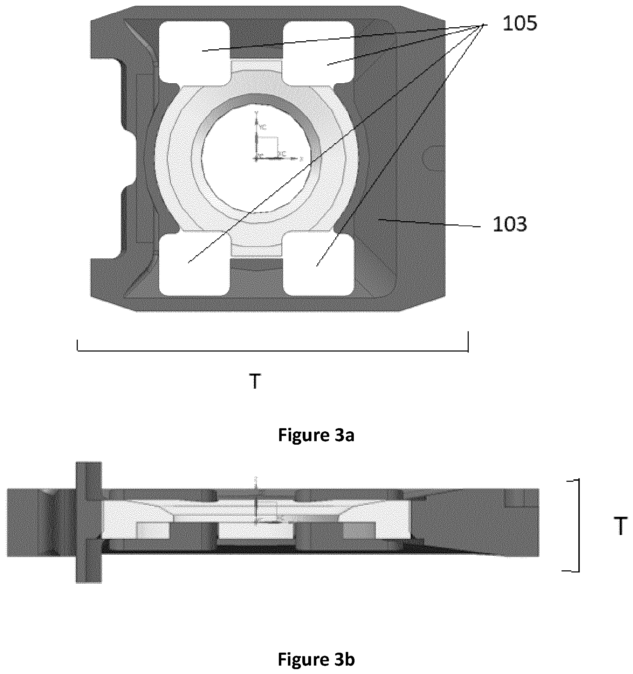

Figures 3a and 3b illustrate an embodiment of the sample tip T.

In Figure 3a, the sample tip T is shown in top (plan) view, with the cradle 101 shown in the bumper 102 with the second surface visible.

The bumper 102 surrounds the external edge of the cradle 101.

In the embodiment illustrated in Figure 3a, when the cradle and bumper are combined, the tip comprises four openings/voids 105 positioned between the cradle 101 and the bumper.

In Figure 3b, the sample tip T is shown in front-side (elevation) view.

As shown, the cradle is positioned toward the proximal end of the sample tip T, with the surfaces of the bumper 102 sloping towards the cradle.

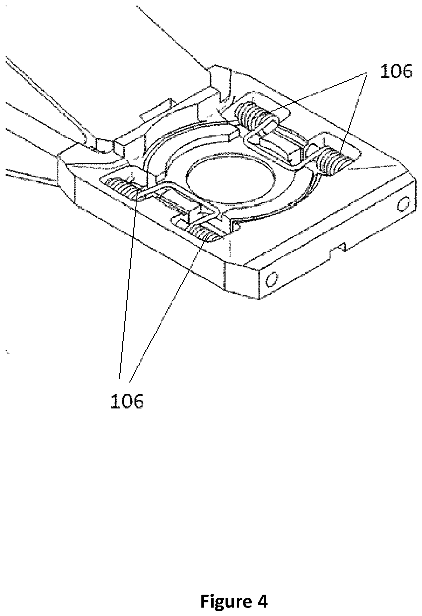

Figure 4 illustrates an embodiment where the sample tip T is connected at the proximal end to a sample holder H, that is connectable to the stage A' of the positioning device A as shown in Fig. 1.

In Figure 4, two fixing elements 106 in the form of a spring-based clamping members are shown. The four openings/voids 105 (as shown in Figure 3a), provide space for the spring part of the clamping member.

The fixing elements 106 are movably connected to the bumper 102, wherein said fixing elements (in the form of spring-based clamping members) are movable between an open position (not shown) and a closed position (shown in Fig. 4).

In the open position, fixing elements (in the form of spring-based clamping members) are moved away from the recess 103, such that it enables a sample grid to be placed in said recess 103. In the closed position, the fixing elements (in the form of spring-based clamping members) locks the sample grid in said recess 103.

As noted above, in the embodiment shown, the fixing elements are in the form of spring-based clamping members, that is pivotable between the open position and the closed position. By providing a spring element, it is possible to force the fixing elements (in the form of spring-based clamping members) towards the closed position, keeping the sample grid tightly in position, when placed inside said recess 103.

## Claims

1. A sample tip for releasably holding a sample, wherein the sample tip comprises:
a cradle comprising beryllium, with a recess for releasably receiving a sample; and
a bumper comprising aluminium.

2. The sample tip according to claim 2, wherein the cradle comprises a first surface and a second surface and the first and second surfaces are substantially parallel to each other.

3. The sample tip according to claim 1 or 2, wherein the bumper extends in the same plane as the cradle.

4. The tip according to any one of the preceding claims, wherein the tip comprises at least one fixing element for releasably holding the sample.

5. The tip according to any one of the preceding claims, wherein the recess is releasably configured to receive a sample grid.

6. The tip according to claim 5, wherein the sample grid is for a charged particle microscope.

7. The tip according to any one of the preceding claims, wherein the tip is releasably connected to a sample holder or is releasably connected to a sample stage.

8. The tip according to any one of the preceding claims, wherein the cradle recess is substantially circular.

9. The tip according to any one of the preceding claims, wherein the cradle recess comprises a substantially central void.

10. The tip according to claim 9, wherein the void is substantially circular.

11. The tip according to any one of the preceding claims, wherein the cradle consists essentially of beryllium.

12. The tip according to any one of the preceding claims, wherein the bumper consists essentially of aluminium.

13. A charged particle microscope for examining a sample, comprising:
- an optics column, including a charged particle source and an illuminator for directing a beam of charged particles emitted from said charged particle source onto a sample;
- a sample tip according to any one of the previous claims 1-12, for holding a sample grid with said sample therein, and positioned downstream of said illuminator;
- an EDX detector device for detecting x-ray emissions originating from said sample in response to the incidence of charged particles emitted from said charged particle source; and
- a control unit for performing operations of the charged particle microscope.

14. A method for inspecting a sample through multiple charged particle beams, wherein the method comprising:
- providing a charged particle beam;
- providing a sample on a sample tip as defined in claims 1 to 12;
- directing the beam through the sample;
- detecting the energies of the x-rays emitted from the sample.
